# EUROPEAN PATENT APPLICATION

(11) **EP 2 088 420 A1**
(43) Date of publication of application: **12.08.2009**
(21) Application number: 07792945.3
(22) Date of filing: 24.08.2007
(51) Int. Cl.: G01N 13/12

(54) **METALLIC PROBE, METHOD OF FORMING THE SAME AND METALLIC PROBE FORMING APPARATUS**

(30) Priority: 30.11.2006 JP 2006322924
(71) Applicant: Japan Science and Technology Agency, Kawaguchi-shi, Saitama 332-0012 (JP)
(72) Inventor: FUJITA, Junichi, Sakuragawa-shi Ibaraki 309-1243 (JP)
(74) Representative: Hoarton, Lloyd Douglas Charles
(86) International application number: PCT/JP2007/066406
(87) International publication number: WO 2008/065790

(57) **Abstract**

A sharpened metallic probe having a top of main body comprising a carbon-containing metal and a method and an apparatus for fabricating the metallic probe are provided. Metallic probe 9 with an extremely sharpened tip is obtained by inducing a field emission from the tip of the main body of the metallic probe 2 where a nanotube 1 is joined thereto, heating and melting locally the tip of the main body of the metallic probe 2 by a Joule heating, and tearing the nanotube 1 toward a counter electrode (4) by a Coulomb attractive force.

## Description

### Technical Field

The present invention relates to a method for fabricating a metallic probe and the metallic probe fabricated thereby, and more particularly, relates to an extremely sharpened nano-level metallic probe used for local measurement in a semiconductor ultra fine region and a method and an apparatus for fabricating the metallic probe.

### Background Art

Due to the progress in the ultra fine lithography technology using an electron beam, and a short wavelength light such as ultra violet and extreme ultra violet, an ultra large scale (LSI) integrated circuit device has miniaturized extremely to achieve 50 mn of line width, and furthermore a large scale production in this extremely fine technological region is considered.

While such an extremely fine semiconductor device is produced, a probe for local measurement becomes indispensable for an analysis of failure such as short circuiting and cutting of interconnections. Currently, a sharp edge probe fabricated with relative ease by electrolytic polishing and by microscopic polishing using an ion beam has a tip radius of curvature of approximately tens of nm, and the probe is used as an electrode probe.

However, as the line width of ultra LSI devices is much miniaturized, a radius of curvature of a tip (front edge) of the local measurement probe is desired to be much smaller.

Generally, an electrolytic polishing method as described in the following Non-Patent Document 1 is used for sharpening such a probe tip. When an alternating current is applied to a tungsten wire mother material to be a probe in an electrolytic solution such as potassium hydroxide (KOH) using counter electrode such as graphite, the tungsten wire tip is polished to be sharpened. By using such a technology, generally a probe having a tip radius of curvature from tens to hundreds of nanometer (nm) is fabricated, and is used as a probe in a scanning probe microscope. However, a limit of the radius of curvature of the probe tip is about 100 nm when a metallic probe is fabricated by an electrolytic polishing method.

Then, as described in following Non-Patent Document 2 and 3, a method for bonding a carbon nanotube (CNT) with a diameter of about 10 nm to the metallic probe tip and using it as a probe for a scanning tunneling microscope (STM) and the like is proposed. However, this method does not widely spread yet.

The reason for the limited prevail lies in difficulty in measurement repeatability due to large contact resistance between the CNT and the metallic probe and in weakness in the mechanical bonding force between the CNT and the metallic probe and so on.

On the other hand, as shown in following Non-Patent Document 4, a technological feasibility to avoid the issue on the contact resistance with a CNT by coating the entirety of CNT connected metallic probe with a metallic film having a thickness of serveral mis also proposed. It is shown that by using the CNT probe coated by a metallic film, not only an STM image but also a normal scanning tunneling spectrum can be obtained, and a flexibility of a CNT originally is not lost even coated with the metallic film.
[Non-Patent Document 1] R. Fainchtein and P.R. Zarriello, "A computer-controlled technique for electrochemical STM tip fabrication", Ultramicroscopy, Vol. 42-44, pp. 1533-1537 (1992) : Elservier Science Publishers B. V.
[Non-Patent Document 2] Y. Shingaya, et al., Physica, B323, (2002), pp.153.
[Non-Patent Document 3] M. Ishikawa, et al., Japan. J. Appl. Phys., 41, (2002), pp.4908.
[Non-Patent Document 4] T.Ikuno, et al., Jpn. J.Appl. Phys., 43, (2004), pp.L644.

### Disclosure of Invention

As described above, SIM technology has made a great progress with an electrolytically polished probe and a nanotube combined probe. However, a tip radius of curvature of the probe for coating a 10 nm nanotube with a metallic film of several nm eventually becomes about 20 nm. By taking account of 30 nm node technology being under discussion, for a next generation ultra LSI technology, it is necessary to realize a sharp measuring probe having a much smaller tip radius of curvature, at least about several nm order. Furthermore, considering a mechanical strength and a contact resistance resulting from the complex structure, a sharpened probe formed of metals made of a similar kind of elements as a unified structure is favorable. Although an ultra fine tip can be fabricated generally by expanding a metallic rod under heat treatment at a temperature below the dissolution point, it is especially difficult to expand a refractory metal to realize a nanoscale tip.

In viewing the above mentioned situation, the present invention aims at providing an extremely sharp metallic probe and a method and an apparatus for fabricating the metallic probe, the top (front edge portion) of the main body of the metallic probe comprises a carbon-containing metal.

To achieve the object described above, the present invention provides;
[1] a metallic probe, wherein a top of the main body of the metallic probe comprises carbon and at least one selected from a group of tungsten (W), hafnium (Hf), rhodium (Rh), rhenium (Re), osmium (Os), tantalum (Ta), iridium (Ir), molybdenum (Mo), zirconium (Zr), titanium (Ti), platinum (Pt), and ruthenium (Ru).
[2] the metallic probe in the above description [1], wherein the top of the main body of the metallic probe has a radius of curvature of 10 nm or less, comprises a carbon-containing amorphous phase.
[3] the metallic probe in the above description [1] or [2], wherein the metallic probe is an emitter for a field emission device.
[4] a method for fabricating a metallic probe, comprising a step of locally melting a top of the main body of the metallic probe, a step of mixing carbon in, and a step of expanding the top of the main body of the metallic probe.
[5] a method for fabricating a metallic probe, comprising a step of contacting a rear edge portion of a carbon nanotube with the top of the main body of the metallic probe, a step of fabricating a carbon nanotube joined probe by locally irradiating an electron beam to the contact part, and depositing a dissociation product (contamination) of carbon to the contact part in order to join the carbon nanotube with the main body of the metallic probe, a step of melting the top of the main body of the metallic probe by applying a voltage between the top of the carbon nanotube and a counter electrode disposed to be facing to the top of the carbon nanotube, a step of expanding the topof the main body of the metallic probe and separating the carbon nanotube from the main body of the metallic probe, and a step of forming a of the main body of the metallic probe having a radius of curvature of 10 nm or less by performing the separation step.
[6] the method for fabricating a metallic probe in the above description [4] or [5], wherein the main body of the metallic probe comprises a metallic probe having a tip sharpened by electrolytic polishing.
[7] the method for farbricating a metallic probe in the above description [5], wherein the carbon nanotube and the main body of the metallic probe are joined by a dissociation product produced by an electron beam irradiation with hydrocarbon based gas as a source material.
[8] an apparatus for fabricating a metallic probe, comprising a carbon nanotube cartridge, a means for fabricating a carbon nanotube joined probe by contacting a rear edge portion of the carbon nanotube on the cartridge with a top of a probe sharpened by electrolytic polishing, acounter electrode disposed to face to the top of the carbon nanotube, a means for applying a voltage between the counter electrode and the top of the carbon nanotube joined probe in order to melt the top of the main body of the metallic probe, and a means to expand the top of the main body of the metallic probe by pulling the carbon nanotube toward the counter electrode by a Coulomb attractive force originated from electric charges stored at the top of the carbon nanotube and to separate the carbon nanotube from the main body of the metallic probe, thereby forming an extremely sharp top having a radius of curvature of 10 nm or less at a position of the top of the main body of the metallic probe.

In other words,(1) A metallic probe with extremely sharp top can be provided by a step of joining a carbon nanotube to a metallic probe tip sharpened by electrolytic polishing, a step of melting locally the joining portion by a Joule heating, and a step of separating the carbon nanotube and the metallic probe from each other.
(2) The method for fabricating the metallic probe in the above description (1) is **characterized in that** a counter electrode is disposed at an extreme vicinity of the carbon nanotube tip, that a voltage is applied between the counter electrode and the carbon nanotube, thereby inducing an electric field emission from the carbon nanotube tip, and that the metallic probe tip is heated due to a Joule heating resulting from the electric field emission.
(3) The method for fabricating the metallic probe in the above description (1) is **characterized in that** Coulomb attractive force between the counter electrode and the carbon nanotube is used for expanding the top of the main body of the metallic probe by the carbon nanotube and separating the top from the carbon nanotube.
(4) The method for fabricating the metallic probe in the above description (1) is **characterized in that** amorphous carbon deposition using an electron beam dissociation deposition method with hydrocarbon based gas as a source material is used for joining the carbon nanotube with the main body of the metallic probe.
(5) A sharpened metallic probe with unified structure is provided, wherein the metallic probe is fabricated by using a method in the above description (1) to (4).

In short, the present invention provides a method for fabricating an extremely sharpened probe using metallic elements such as tungsten (W) and iridium (Ir), wherein an extremely sharpened metallic probe having a tip radius of curvature as small as 10 nm or less can be fabricated by a step of joining a carbon nanotube to the metallic probe tip sharpened by electrolytic polishing using amorphous carbon produced by an electron beam excitation reaction, a step of melting the joining part with the metal by a Joule heating resulting from an electric field emission between a counter electrode (anode) and the carbon nanotube, and a step of expanding the melted part using a Coulomb attractive force acts between the counter electrode and the carbon nanotube while being melted.

### Brief Description of the Drawings

Fig. 1 is a schematic illustration showing a method for fabricating an extremely sharpened metallic probe according to an embodiment of the present invention.
Fig. 2 is a diagram illustrating a scanning electron microscope (SEM) image of a probe tip according to an embodiment of the present invention.
Fig. 3 is a diagram showing electric field emission characteristics of sharpened tungsten probe tip according to the present invention.
Fig. 4 is a diagram showing a Fowler-Northeim (FN) plot of the electric field emission characteristics of the probes shown in Fig. 3 (b) and (c).
Fig. 5 is a diagram illustrating electric field emission characteristics when a distance between a counter electrode (anode) and a probe tip is fixed to be 10 µm.
Fig. 6 is a high resolution transmission electron microscope (TEM) image of a probe tip.
Fig. 7 is a schematic illustration of a multi walled (MW) CNT cartridge according to the present invention.
Fig. 8 is a schematic illustration showing operations of joining and pulling a CNT from a cartridge to a probe tip according to the present invention.

### Best Mode for Carrying Out the Invention

Potential needs are very strong toward a sharpened probe. Recent progress in LSI is especially remarkable and the line width of a dynamic random access memory (DRAM) is decreasing to less than 50 nm. As a testing probe for LSI with such an ultra fine structure, a radius of curvature of the probe tip is requested to be much smaller than the structure of an object under test. A tungsten probe sharpened by electrolytic polishing using a solution such as Sodium Hydroxide (NaOH) or Potassium Hydroxide (KOH) typically has a tip radius of curvature within a range of 50 to 100 nm. By a highly strict control of polishing process, a radius of curvature of as small as 20 nm can be achieve, however, it is a very difficult process in practice.

On the other hand, in the fabrication of an extremely sharpened metallic probe disclosed by the present invention, a polished metallic (tungsten) probe is joined with a multi walled CNT, to which a strong electric field is then applied. Joining step of the metallic (tungsten) probe with the multi walled CNT is performed by using residual hydrocarbon present in a sample chamber of a scanning electron microscope. After contacting the multi walled CNT with the metallic (tungsten) probe by using a micro manipulator, and locally irradiating an electron beam to the contact part, carbon containing dissociation product (contamination) is deposited over the contact part, thereby joining the multi walled CNT with the metallic (tungsten) probe. Using a CNT in the sharpening process of the metallic (tungsten) probe has following reasons. In this sharpening process, an electric field emission is induced from the multi walled CNT tip, and a Joule heating resulting from a current flowing during the field emission causes the metallic (tungsten) probe tip to melt. In this situation, however, the multi walled CNT itself does not melt yet, but only the metallic (tungsten) probe tip melts. At the same time, the multi walled CNT is pulled toward the counter electrode by a Coulomb attraction force due to the electric charges stored at the CNT trip and the metallic (tungsten) probe top is expanded.

Under a viewing field of a general purpose scanning electron microscope, when a distance between the counter electrode and the multi walled CNT tip is set to be about 10 µm and an electric field is applied between them, an electric field emission from the multi walled CNT tip can be observed at an applied voltage of about 100 V. By increasing the electric potential furthermore, the main body of the multi walled CNT and the metallic (tungsten) probe tip are heated, and a secondary electron image of the scanning electron microscope (SEM) soon disappears due to a free electron emission. Even in this situation, deformation process due to heating and melting of the metallic (tungsten) probe tip can be monitored with a scanning transmission electron microscope (STEM) apparatus if it is available. By increasing an applied voltage suddenly when the tip expands moderately, the multi walled CNT is be torn toward the counter electrode while keeping to hold the metallic (tungsten) probe tip. Then, an extremely sharpened metallic (tungsten) probe tip is formed at the position of metallic (tungsten) probe tip. In other words, this sharpening process can be performed since the multi walled CNT does not melt even at a dissolution temperature of the metallic (tungsten) probe and other refractory noble metal probe and since the contamination due to hydrocarbon keeps the multi walled CNT in contact with the metallic probe tip even at a dissolution temperature of the refractory noble metal.

As described above, as a method for fabricating an extremely sharpened metallic probe by inducing an electric field emission by applying an external electric potential to the metallic probe tip which joins a multi walled CNT, the present invention is based on following embodiments;
(1) a metallic probe with an extremely sharpened tip is formed by a step of joining a multi walled CNT to a metallic probe tip sharpened by electrolytic polishing, a step of locally melting the joined part by using a Joule heating, and a step of separating the multi walled CNT and the metallic probe from each other.
(2) in the method for fabricating the metallic probe, a counter electrode is disposed at an extreme vicinity of the multi walled CNT tip, an electric field emission is induced from the multi walled CNT tip by applying an electric potential between the counter electrode and the multi walled CNT, and the metallic probe tip is heated by a Joule heating resulting from the electric field emission.
(3) in the method for fabricating the metallic probe, Coulomb attractive force between the counter electrode and the multi CNT is used for expanding and separating the metallic probe tip by the multi walled CNT.
(4) in the method for fabricating the metallic probe, the multi walled CNT and the metallic probe are joined by amorphous carbon deposit using an electron beam dissociation deposition method utilizing hydrocarbon gas as a source material.
(5) in the method for fabricating an extremely sharpened probe made of metallic elements such as tungsten (W), iridium (Ir), the present invention provides a technology for fabricating a metallic probe with an extremely sharpened top having a tip radius of curvature as small as 10 nm or less by a step of joining a multi walled CNT to a roughly sharpened metallic probe tip by amorphous carbon produced by an electron beam excitation reaction, a step of melting the joined part with the metal by a Joule heating associated with an electric field emission between a counter electrode (anode) and the multi walled CNT, and by a step of expanding at the same time the melted portion by utilizing a Coulomb attraction force between the counter electrode and the multi walled CNT.

### EMBODIMENT

Embodiments according to the present invention will be described in detail in the following. In the description, a probe made of tungsten is taken as an example.

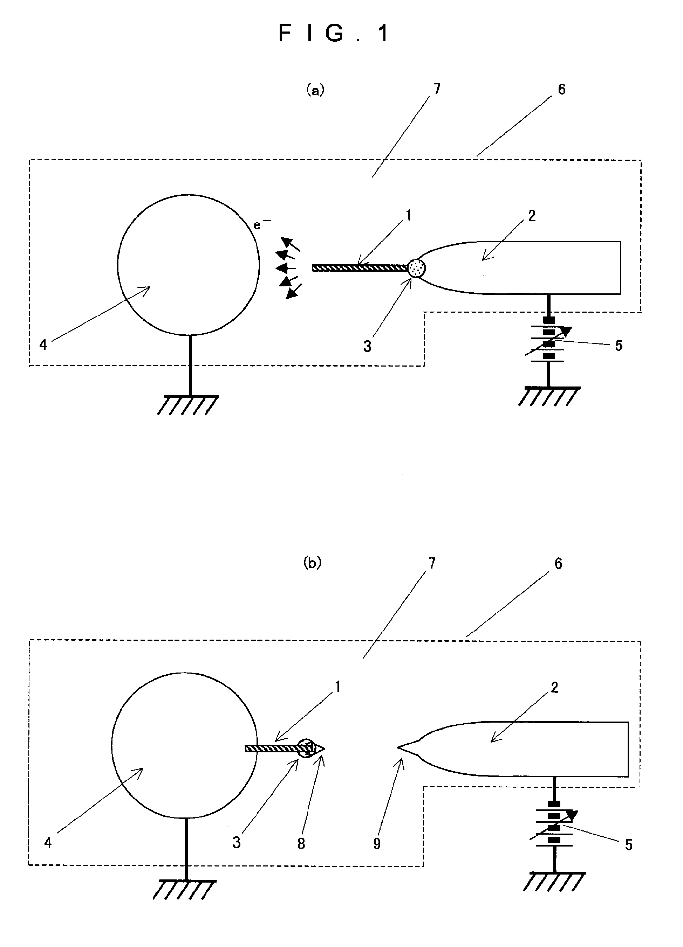

Fig. 1 is a schematic diagram showing a method for fabricating an extremely sharpened metallic probe according to an embodiment of the present invention. Fig. 1(a) shows an explanatory diagram of a first half of the fabrication process, and Fig. 1(b) shows an explanatory diagram of the remaining half of the fabrication process.

In these figures, reference numeral 1 denotes a carbon nanotube (multi walled CNT), 2 denotes a main body of the metallic probe made of a metal (refractory metal, such as tungsten (W) and iridium (Ir)) sharpened by electrolytic polishing, 3 denotes a joined part by means of carbon contamination, 4denotes a counter electrode, 5denotes a high voltage supply source, 6 denotes a sample chamber of a general purpose scanning electron microscope, 7denotes gas as a source material within the sample chamber 6 of the general purpose scanning electron microscope, 8denotes a lump of a main body of the metallic probe (tungsten) torn off at the joining position with a CNT; 9denotes a metallic probe having an extremely sharpened top including carbon to be fabricated according to the present invention. In short, a metallic probe 9 having an extremely sharpened top with a radius of curvature of the probe tip of 10 nm or less, with the minimum value being 2 nm can be fabricated. In addition to tungsten (W) and iridium (Ir) described above, as a carbon containing metal for the top of the main body of the metallic probe, hafnium (Hf), rhodium (Rh), rhenium (Re), osmium (Os) tantalum (Ta), molybdenum (Mo), zirconium (Zr), titanium (Ti), platinum (Pt), ruthenium (Ru) can be used.

A fabrication process of an extremely sharpened metallic probe according to the present invention is described below.

First, a fabrication apparatus of a metallic probe is set in a sample chamber 6 of a general purpose scanning electron microscope. Residual hydrocarbon gas in the sample chamber 6 is source material gas 7 for contamination. It is to be understood that hydrocarbon gas such as, for example, phenanthorene or pyrene can also be used as source material gas by installing a specific gas nozzle. In the manipulation of a CNT in the present embodiment, a cartridge where CNTs are dispersed over an edge of a safety razor blade was used. After breaking commercially available multi walled CNTs into piece with an agate mortar, disperse them into an ethanol solution using combination of a supersonic wave. By dropping a droplet of the solution where CNTs are dispersed on to about 50 µm of gap between two opposite razor blade edges, and applying a voltage 20 V at high frequency of about 1 MHz, CNTs are dispersed on the blade edges. By using the cartridge where CNTs are dispersed on the blade edge, a single CNT is transferred to a nano-manipulator tip in the SEM chamber. Also in this process, a CNT 1 is contacted to the manipulator tip and an electron beam is irradiated locally, carbon contamination at the irradiated position. By moving the manipulator in this situation, a single piece of CNT joined to the manipulator tip can be pulled off from the cartridge. The resulting CNT1 is contacted with a tip of a main body of the metallic probe 2 to be sharpened by operating the manipulator, and joined also by using the electron beam irradiation. Here the CNT1 should be fixed loosely at the manipulator tip and fixed strongly at the tip of the main body of the metallic probe 2 to be sharpened By removing the manipulator after the fixing of the CNT1 at the tip of the main body of the metallic probe 2 is completed, a metallic probe with a CNT fixed at the tip can be formed. Ideally, the above procedure should be performed in a sufficiently stable sample chamber 6 in a general purpose scanning electron microscope while observing the microscope image. In the next step, a counter electrode 4 is disposed against the CNT tip with a spacing of about 10 µm, and a negative electric potential is applied to the main body of the metallic probe 2 as shown in Fig. 1(a). An electric field emission starts to be observed from the CNT 1 tip at an applied voltage of above 100 V, and a temperature of the tip of the main body of the metallic probe 2 gradually increases. As the temperature rise, secondary electron emission from the surface of the main body of the metallic probe 2 and from the surface of the CNT1 increase, and at above 600 °C, the secondary electron image of the SEM whites out. This phenomenon, on the contrary, enables estimating a temperature of the sample.

The situation can not be observed by the secondary electron image beyond this point, however, if the function of STEM (transmission electron detector) is provided, an expansion of the tip of the main body of the metallic probe 2 due to further rise in temperature can be observed.

Although a typical value of a current of the electric field emission under observation is at most µA order, temperatures of the CNT1 and the tip of the main body of the metallic probe 2 is sufficiently high for an expansion of the front edge of the main body of the metallic probe 2 made of tungsten is observed. By increasing the applied voltage suddenly at this stage, the tip of the main body of the metallic (tungsten) probe 2 is torn off due to a Coulomb attractive force of the heat caused by the increase of voltage, the CNT 1 collides with the counter electrode 4, and the electric field emission from the main body of the metallic probe 2 ceases as shown in Fig. 1 (b).

A metallic (tungsten) probe 2 with an extremely sharpened top is obtained in very high rate and the tip radius of curvature of about 5 nm can be obtained easily. In addition, by changing a position relation of the main body of the metallic probe 2 and the counter electrode 4just prior to separate the metallic probe tip in the final step, a metallic probe 9 with a tip having a constricted part can be fabricated.

As described above, the method for fabricating a metallic probe according to the present invention comprises a step of locally melting a top of a main body of a metallic probe, a step of mixing carbon in, and a step of expanding the top of the main body of the metallic probe.

### EXAMPLE

Embodiments of the method for fabricating a tungsten probe according to the present invention will be described in the following.
(1)A CNT at an edge of a cartridge is joined with an electrolytically polished tungsten probe tip by using carbon contamination deposited by an electron beam irradiation. The electron beam current and voltage at this stage are 200 pA, and 15 keV, respectively.
(2) The tungsten probe is pulled out by operating a piezoelectric actuator. A typical size of a CNT has a diameter from about 20 to 50 nm, and the CNT protrudes from the tungsten probe tip by about 1.5 µm.
(3) By operating the actuator, a distance between the CNT and a counter electrode is set at about 5 µm. The tungsten probe side is grounded and the counter electrode side is an anode. From an electric potential of the anode exceeding 110 V, an emission begins from the CNT tip.
(4) At an emission current of about 10 pA, the secondary electron image of the SEM whites out (although depending on a diameter of the tungsten probe). This indicates that a temperature of the CNT and the tungsten probe tip 600°C and the free electron emission has started.
(5) When an emission current is increased gradually (increasing rate of an electric potential is typically about 1 V/sec) and reaches at the emission current from 10 to 15 µA, the tungsten probe tip joining with the CNT is torn off by a Coulomb attractive force. By detecting an instantaneous drop of the emission current, the electric potential of the anode is automatically shut down. A metallic probe with the extremely sharpened top is thus fabricated, with a probe tip having a radius of curvature of 10 nm or less with the minimum value of 2 nm.

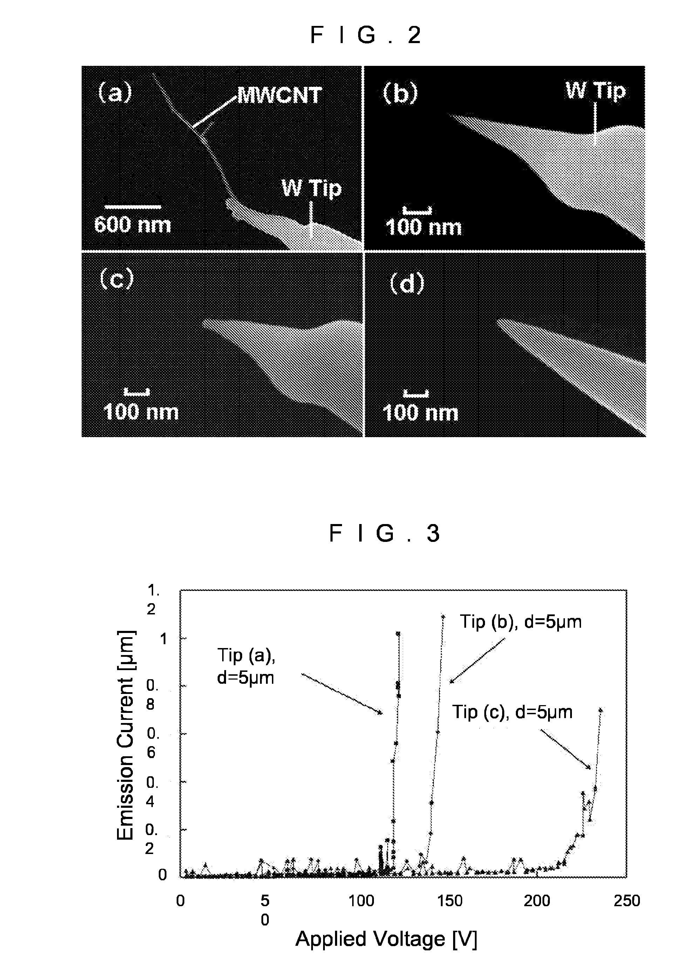

Fig. 2 shows an SEM image of a probe tip according to an embodiment of the present invention.

Fig. 2 (a) shows a tungsten probe joined with an MW (multi walled) CNT, Fig. 2 (b) is an extremely sharpened tungsten probe tip according to the present invention, and the radius of curvature of this tungsten probe tip is 5 nm or less. Fig. 2 (c) is a probe with a rounded tip as a reference example. Fig. 2 (d) is a probe tip just after an electrolytic polishing.

A tip radius of curvature realized by electrolytic polishing is typically 50 nm, and when optimizing the condition and advancing the polishing skill, a tip radius of curvature as small as 20 nm can be fabricated as shown in Fig. 2 (d). However, it is almost impossible to fabricate a tip radius of curvature as small as several nm as shown in Fig. 2 (b) by an electrolytic polishing.

Fig. 3 shows electric field emission characteristics of a CNT joined probe tip.

Here, a distance between the counter electrode (anode) and the CNT tip is 5 µm. An electric field emission starts from the CNT tip when a voltage applied to the counter electrode is about 120 V. The electric field emission current increases with increasing the applied voltage, and at an emission current of about 10 nA, the normal SEM (scanning electron microscope) image becomes invisible. This is due to a saturation of the secondary electron detector of the SEM resulting from the free electron emission caused by an increase in temperature of the tungsten probe tip (contact part with the CNT). When increasing the emission furthermore, the tungsten probe tip is melt at a current of about 1 µA, the CNT is pulled toward the counter electrode (anode), and the tungsten probe tip is torn. At this instance, an extremely sharpened tip is formed at the position of the tungsten probe tip.

As for the electric field emission characteristics of the extremely sharpened the tungsten probe tip, an emission starts with a very low threshold value as shown in Fig. 3 (b). This is because a strong electric field is formed locally only at a vicinity of the tungsten probe tip due to a very strong concentration of electric field occurs at the extremely sharpened the tungsten probe tip. An electric field emission characteristic from a rounded tungsten probe tip with the same measurement condition is shown as (c) of Fig. 3. Since (b) and (c) of Fig. 3 are for the same tungsten, the surface work function is the same. The difference in the threshold values at the start of the emission between the both tungsten probes reflects the difference in an extent of the concentration of local electric field. The concentration of the electric field is expressed by a parameter which is referred to as an enhancement factor.

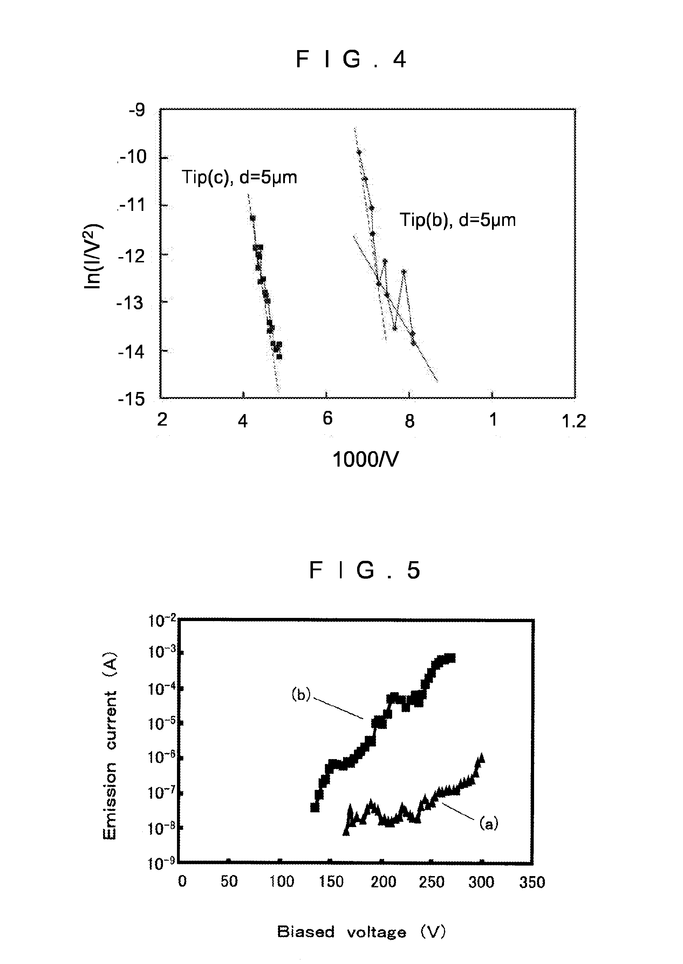

Fig. 4 shows an FN (Fowler-Northeim) plot of the electric field emission characteristics of the probes shown as (b) and (c) of Fig. 3. In this figure, electric field emission current j [A] is expressed by the following expression with an electric field strength F [V/m] and the work function φ [eV].

However, the electric field F is generally defined by F=γF_{M} due to an enhancement effect γ where F_{M} is an average electric field strength between the anode and the probe tip F_{M}=V/d. The difference in gradient between the tungsten probe (c) with a rounded tip and the tungsten probe (b) with an extremely sharpened tip is due to the difference in local electric field strength. Here, a rise up of the electric field emission for the extremely sharpened probe as shown in Fig. 4 (b) has a more gentle slope in the FN plot, indicating a large enhancement factor in local electric field strength. However, the slope is changed to substantially same slope of the rounded tungsten probe shown as (c) of Fig. 4. The extremely sharpened tungsten probe tip, although it is made of tungsten, melts by a Joule heating by a small amount of electric field emission current. That is, the tip is then melted and rounded. At this stage a thermionic emission has already started, and the electric field emission goes on but the shape of tip has already been rounded.

The data shown as (c) of Fig. 4 is a data of the electric field emission characteristics measured again after an electric field emission from this extremely sharpened tungsten probe (b) . In this manner, the extremely sharpened tungsten probe tip is apt to melt with even a small amount of electric field emission current.

This easiness to melt depends strongly on how to pull the top of the tungsten, in other words, on an angle of the tungsten probe tip. For a relatively obtuse-angled tungsten probe, the tip melts and rounds due to the electric field emission less significant due to its large thermal conduction, however, for an acute-angled (sharpened) the tungsten probe tip, the tip tends to round easily due to its small thermal conduction. However, on the other hand, for some probes, such as a probe for an LSI tester, a sharp tip is desirable though current is not applied. In this case, by spending much of time in expanding the tungsten probe tip, an extremely sharpened tip with a very small angle can be fabricated. For example, an extremely sharpened top having a radius of curvature of the probe tip of 10 nm or less with the minimum value of 2 nm can be fabricated.

However, on the other hand, when the tungsten probe is used as an electron emitter, current tolerance can be improved by making the tip angle obtuse to increase thermal conduction, thereby suppressing the Joule heating accompanied by the emission current.

In addition, the extremely sharpened metallic probe described above can be used as an emitter for an electric field emission device, and especially it has been confirmed that it can be used as an emitter for an electric field emission device which is tolerable to an emission at large current (about 1 mA).

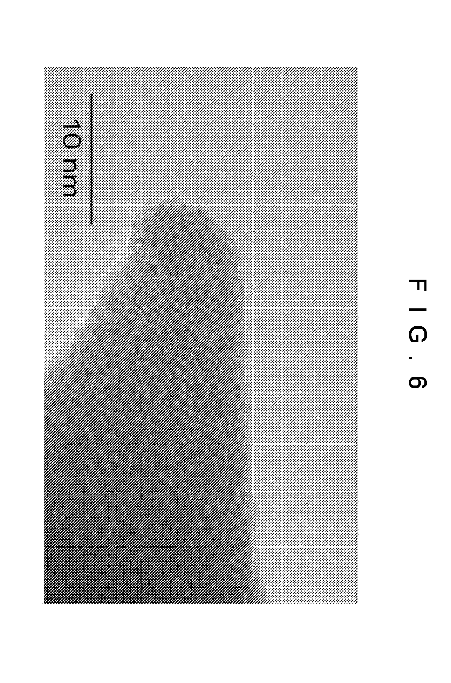

Fig. 5 shows a diagram illustrating electric field emission characteristics when a distance between a counter electrode (anode) and a probe tip is fixed to be 10 µm. Fig. 6 is a high resolution transmission electron microscope (TEM) image of the probe tip.

Commonly available electrolytic polished tungsten probe has a high threshold voltage for onset of the electric field emission and the tip is melted at an emission current of about 1 µA, as shown in (a) of Fig. 5. On the other hand, a probe having a CNT joined top has a starting voltage for the electric field emission as low as about 100 V, and an emission current can reach about 10 µA. By applying more emission current under control, an extremely sharpened probe with a melted tip can be fabricated as shown in Fig. 6. It should be noted here that the resulting extremely sharpened metallic probe can emit an electric field emission current exceeding 1000 µA, as shown in (b) of Fig. 5 This current tolerance value is more than 1000 times of that of the typical electrolytically polished tungsten probe which is used in a standard STM. A high resolution TEM image of the resulting extremely sharpened probe tip shows that the probe tip is amorphous, and an energy dispersive X-ray spectroscopic (EDX) analysis shows that main component materials are tungsten and carbon. Therefore it is confirmed that the probe top is made of tungsten having amorphous phase mixed with carbon. In addition, the probe top may be coated by these materials.

In the following, a method for fabricating a cartridge of an MW (multi walled) CNT will be described.

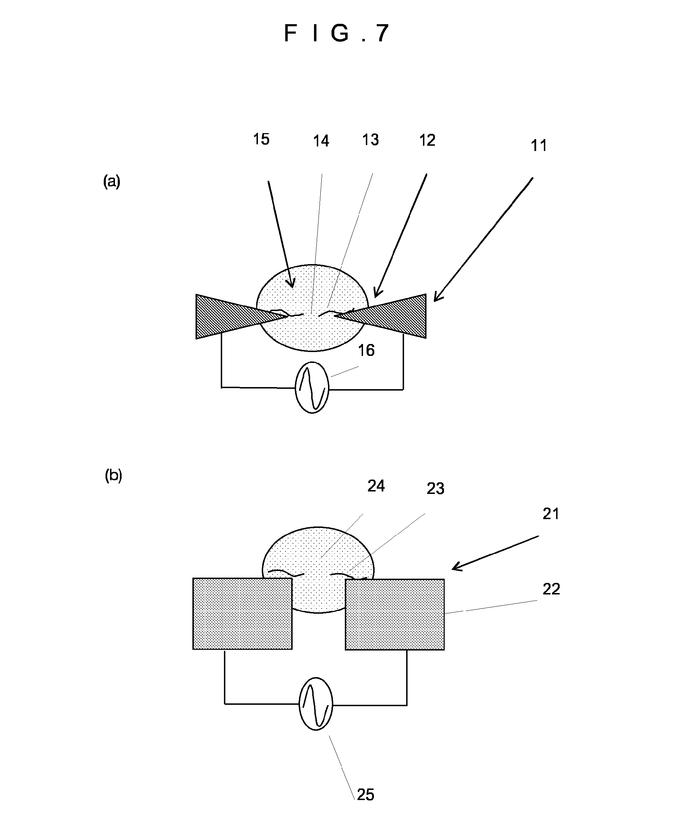

Fig. 7 is a schematic illustration of an MW CNT cartridge according to the present invention.

In order to fabricate an extremely sharpened metallic probe, first of all, a cartridge 11 where MW CNTs 13 are arranged along a knife edge 12 is fabricated as shown in Fig. 7 (a).

Commonly, a gap 14 is set to be 50 µm by arranging knife edges (razor blades) 12 (as described in, for example, Appl. Phys. Lett., 4061-4063(1999)). When a droplet of a MW CNT solution dispersed in alcohol (CNT dispersed IPA (isopropyl alcohol)) 15 is dropped into the gap 14 and an alternating voltage 16 is applied between these knife edges 12, MW CNTs 13 are arranged perpendicularly to the knife edges 12 by a dipole force. After fabricating such an MW CNT cartridge, an MWCNT is joined with a desired probe tip (not shown) by utilizing carbon contamination.

On the other hand, as shown in Fig. 7(b), using a cleavage plane of a silicon substrate 22 for constructing a cartridge 21 is generally considered not advantageous from a view point of arranging multi walled CNTs 23 along a edge since the cleavage plane is perpendicular to the substrate plane when, for example, (100) substrate plane is used, However, actually an edge realized by cleaving a silicon substrate 22 is much sharper as compared with a diameter of the multi walled CNTs 23. In the present embodiment, arrangement of multi walled CNTs 23along an edge of a silicon substrate by a dipole force is performed using a doped silicon substrate 22 with a sheet resistance of about 1 Ω.

Multi walled CNTs 23 dispersed in a multi walled CNT solution 24 by a supersonic wave are arranged perpendicularly to the silicon substrate 22 by a dipole force when applying an alternating voltage of about 1 MHz between opposing edges made from cleavage planes of the silicon substrate 22.

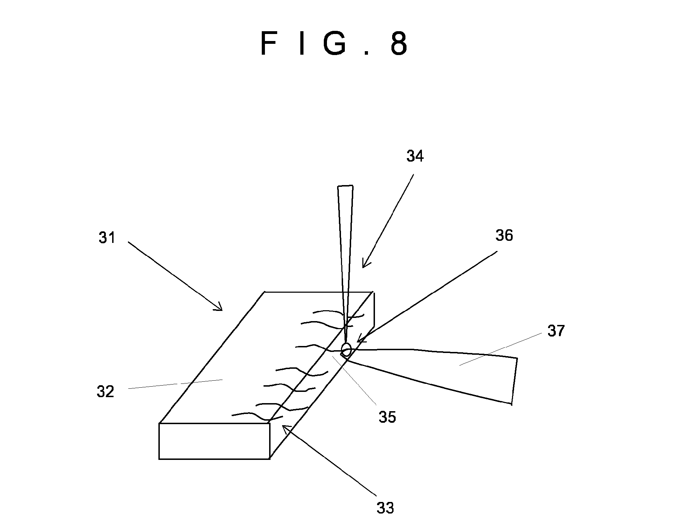

Fig. 8 shows a schematic illustration of operations of joining and pulling a CNT from a cartridge to a probe tip according to the present invention.

After arranging multi walled CNTs 35 along an edge 34 of a cleavage plane 33 of a silicon substrate 32 comprising a cartridge 31, and joining a multi walled CNT 35 on the edge 34 rigidly with an electrolytically polished probe tip 37 by means of a carbon contamination joint 36, the probe 37 is separated from the cartridge 31 slowly. Since the multi walled CNT 35 is only physically adsorbed via an impurity in an alcohol or due to a van der Waals force, it can be detached from the cartridge 31 very easily, thereby completing the probe with the multi walled CNT 35.

In addition, while the present invention is not limited to the embodiment described above, various modifications can be made based on the spirit of the present invention. It is intended that these modifications are not excluded in the scope of the present invention.

According to the present invention, a sharpened metallic probe having a top of the main body of the metallic probe formed of a metal including carbon can be fabricated.

Especially, an extremely sharpened metallic probe with a tip radius of curvature of 10 nm or less can be fabricated easily. The probe functions not only as a high resolution probe in the conventional STM and atomic force microscope (AFM) technologies, but also as an inspection probe for semiconductor devices corresponding to the next generation ultra large scale integration circuit technology, and can contribute to the progress in technology and industry of the nanoscale semiconductor device.

### Industrial Applicability

An extremely sharpened metallic probe, a fabrication method and a fabrication apparatus of the metallic probe according to the present invention is a basic technology which enables sharpening a tip made of various materials to a radius of curvature of 10 nm or less with relative ease, and can be utilized as a tester for an ultra large scale integration circuit technology and as a field emission device and so on.

## Claims

1. A metallic probe, wherein a top of the main body of the metallic probe comprises at least one of carbon-containing tungsten (W), hafnium (Hf), rhodium (Rh), rhenium (Re), osmium (Os), tantalum (Ta), iridium (Ir), molybdenum (Mo), zirconium (Zr), titanium (Ti), platinum (Pt), and ruthenium (Ru).

2. The metallic probe according to claim 1, wherein the top of the main body of the metallic probe has a radius of curvature of 10 nm or less, comprising an amorphous phase which contains carbon.

3. The metallic probe according to claim 1 or claim 2, wherein the metallic probe is an emitter for a field emission device.

4. A method for fabricating a metallic probe comprising;
(a) a step of locally melting a top of the main body of the metallic probe,
(b) a step of mixing carbon in, and
(c) a step of expanding the top of the main body of the metallic probe.

5. A method for fabricating a metallic probe comprising;
(a) a step of contacting a rear edge portion of a carbon nanotube with a top of the main body of the metallic probe,
(b) a step of fabricating a carbon nanotube joined probe by locally irradiating an electron beam to the contact part, and depositing a dissociation product (contamination) of carbon to the contact part in order to join the carbon nanotube with the main body of the metallic probe,
(c) a step of melting the top of the main body of the metallic probe by applying a voltage between the top of the carbon nanotube and a counter electrode disposed to face to the carbon nanotube top,
(d) a step of expanding the top of the main body of the metallic probe and separating the carbon nanotube from the main body of the metallic probe, and
(e) a step of forming a top having a radius of curvature of 10 nm or less at a position of the top of the main body of the metallic probe by performing the separation step.

6. The method for fabricating a metallic probe according to claim 4 or claim 5, wherein the main body of the metallic probe comprises a metallic probe with a tip sharpened by electrolytic polishing.

7. The method for fabricating a metallic probe according to claim 5, wherein the carbon nanotube and the main body of the metallic probe is joined by a dissociation product produced by an electron beam irradiation with hydrocarbon based gas as a source material.

8. An apparatus for fabricating a metallic probe comprising;
(a) a carbon nanotube cartridge,
(b) a means for fabricating a carbon nanotube joined probe by joining a rear edge portion of the carbon nanotube on the cartridge with a probe top sharpened by electrolytic polishing,
(c) a counter electrode disposed to face to the carbon nanotube top,
(d) a means for applying a voltage between the counter electrode and the carbon nanotube joined probe top in order to melt the top of the main body of the metallic probe, and
(e) a means for forming an extremely sharpened top having a radius of curvature of 10 nm or less at a position of the top of the main body of the metallic probe to expand the top of the main body of the metallic probe by pulling the carbon nanotube toward the counter electrode by a Coulomb attractive force originated from electric charges stored at the carbon nanotube top and to separate the carbon nanotube from the main body of the metallic probe.
